# EUROPEAN PATENT APPLICATION

(11) **EP 1 391 864 A2**
(43) Date of publication of application: **25.02.2004**
(21) Application number: 03018515.1
(22) Date of filing: 16.08.2003
(51) Int. Cl.: G09G 3/20, G09G 3/32

(54) **Flat display panel**

(30) Priority: 17.08.2002 KR 2002048653
(71) Applicant: LG ELECTRONICS INC., Seoul (KR)
(72) Inventor: Kim, Hak Su, Gangbuk-gu, Seoul (KR); Kim, Chang Nam, Jungnang-gu, Seoul (KR)
(74) Representative: Vetter, Ewald Otto

(57) **Abstract**

Flat display panel including a plurality of data lines arranged in one direction, a plurality of scan lines arranged perpendicular to the data lines, and luminous pixels at cross points of the data lines and the scan lines, wherein at least one scan line forms one group of scan lines, to form a plurality of groups of scan lines in total, luminous pixels on odd numbered groups of scan lines are connected to the first data line electrically, and luminous pixels on even numbered groups of scan lines are connected to the second data line electrically.

## Description

This application claims the benefit of the Korean Application No. P2002-0048653 filed on August 17, 2002, which is hereby incorporated by reference.

### BACKGROUND OF THE INVENTION

### Field of the Invention

The present invention relates to displays, and more particularly, to a flat display.

### Background of the Related Art

Recently, there has been rapid progress made in the field of flat displays. The flat display, starting to make an appearance lead by LCD (Liquid Crystal Display), is developed to PDP (Plasma Display Panel), VFD (Visual Fluorescent Display), FED (Field Emission Display), LED (Light Emitting Diode), EL (Electroluminescence), and the like, passing ahead CRT (Cathode Ray Tube) used mostly in the field of display for tens of years.

The flat displays have advantages in that, not only visibility, but also sense of color is good, and a fabrication process is also simple.

However, the flat display requires the more current for a driving circuit thereof, as a size of the display panel becomes the larger. Moreover, the better the resolution of the flat display, to required the greater number of pixels, the greater numbers of data lines and scan lines are required. The greater the number of scan lines, the shorter a luminous time period of the pixel, that leads to a poor luminance of the display. Accordingly, the flat display requires a large current for obtaining a desired luminance. Consequently, in order to overcome this problem, methods for reducing the number of scan lines are suggested.

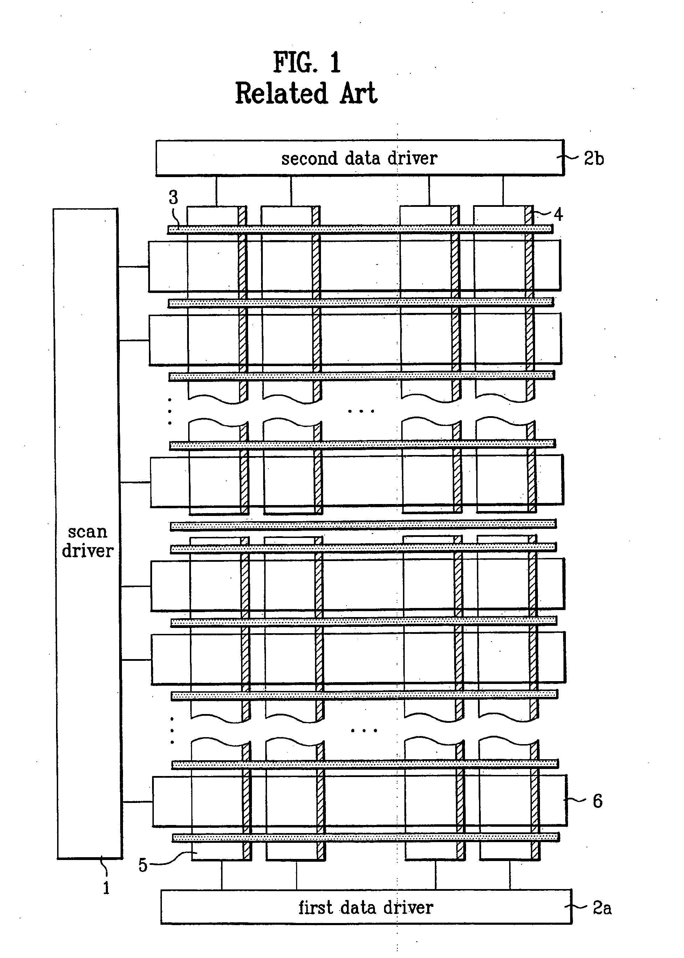

FIG 1 illustrates a diagram showing a related art organic EL display panel.

Referring to FIG. 1, the related art organic EL display panel is provided with data lines 5 and scan lines 6 perpendicular to each other, a pixel in each cross region of the data lines 5 and the scan lines 6, an electric insulating barrier 3 between adjacent scan lines 6, a supplementary electrode 4 at one side of each of the data lines 5, first and second data drivers 2a and 2b for driving the data lines 5, and a scan driver 1 for driving the scan lines 6.

The data lines 5 are divided into data lines 5 driven with the first data driver 2a, and data lines 5 driven with a second data driver 2b. Accordingly, since the scan driver 1 makes scan drive of the two parts of data lines 5 separately, the scan driver 1 has an effect of reducing the number of scan lines.

However, this structure requires two data drivers, and increases a size of an overall display panel. Moreover, this structure requires a complicate display system, and costs high. Furthermore, there may be a difference between the two divided parts of panel, to cause a problem in uniformity and heavy flicker.

### SUMMARY OF THE INVENTION

Accordingly, the present invention is directed to a flat display that substantially obviates one or more of the problems due to limitations and disadvantages of the related art.

An object of the present invention is to provide a flat display which can reduce power consumption.

Another object of the present invention is to provide a flat display which is suitable for a high resolution large sized panel.

Additional features and advantages of the invention will be set forth in the description which follows, and in part will be apparent to those having ordinary skill in the art upon examination of the following or may be learned from practice of the invention. The objectives and other advantages of the invention will be realized and attained by the structure particularly pointed out in the written description and claims hereof as well as the appended drawings.

To achieve these objects and other advantages and in accordance with the purpose of the present invention, as embodied and broadly described herein, the flat display panel including a plurality of data lines arranged in one direction, a plurality of scan lines arranged perpendicular to the data lines, and luminous pixels at cross points of the data lines and the scan lines, wherein at least one scan line forms one group of scan lines, to form a plurality of groups of scan lines in total, luminous pixels on odd numbered groups of scan lines are connected to the first data line electrically, and luminous pixels on even numbered groups of scan lines are connected to the second data line electrically.

The first data line is an odd numbered data line, and the second data line is an even numbered data line of the plurality of data lines.

The scan lines in the odd numbered group of scan lines and scan lines in the even numbered group of scan lines adjacent thereto are driven in the same order at the same time.

In another aspect of the present invention, there is provided a flat display panel including a plurality of data lines arranged in one direction, a plurality of scan lines arranged perpendicular to the data lines, and luminous pixels at cross points of the data lines and the scan lines, wherein two scan line form one pair of scan lines, to form a plurality of pairs of scan lines in total, luminous pixels on odd numbered pairs of scan lines are connected to the first data line electrically, and luminous pixels on even numbered pairs of scan lines are connected to the second data line electrically.

The pair of scan lines are two adjacent scan lines.

The odd numbered pair of scan lines includes a first scan line and a second scan line, and the even numbered pair of scan lines includes a third scan line and a fourth scan line.

The first, and second scan lines in the odd numbered pair of scan lines and the third and fourth scan lines in the even numbered pair of scan lines adjacent thereto are driven in the same order at the same time.

The first scan line of the first pair of scan lines and the first scan line of the second pair of scan lines are driven in response to the first scan signal, the second scan line of the first pair of scan lines and the second scan line of the second pair of scan lines are driven in response to the second scan signal, and other pairs of scan lines are driven according to above driving manner in a sequence.

In a first frame, the first scan line in the first pair of scan lines and the first scan line in the second pair of scan lines are driven at the same time when the first scan signal is provided, and the first scan line in the third pair of scan lines and the first scan line in the fourth pair of scan lines are driven at the same time when the second scan signal is provided, in a second frame, the second scan line in the first pair of scan lines and the second scan line in the second pair of scan lines are driven at the same time when the first scan signal is provided, and the second scan line in the third pair of scan lines and the second scan line in the fourth pair of scan lines are driven at the same time when the second scan signal is provided, and other pairs of scan lines are driven according to above driving manner in a sequence.

The first frame, or the second frame has a time period shorter than one frame time period required for driving entire luminous pixels in the display panel.

The scan signal to the scan line is provided in an interlacing manner.

It is to be understood that both the foregoing description and the following detailed description of the present invention are exemplary and explanatory and are intended to provide further explanation of the invention claimed.

### BRIEF DESCRITPION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings;
FIG 1 illustrates a diagram of a related art organic EL display panel;
FIG 2 illustrates a diagram of an organic EL display panel in accordance with a preferred embodiment of the present invention;
FIG 3 illustrates a timing diagram of scan drive waveforms of an organic EL display panel in accordance with a preferred embodiment of the present invention.

### DETAILED DESCRIPTION OF THE PREFERRED EMBODIMENT

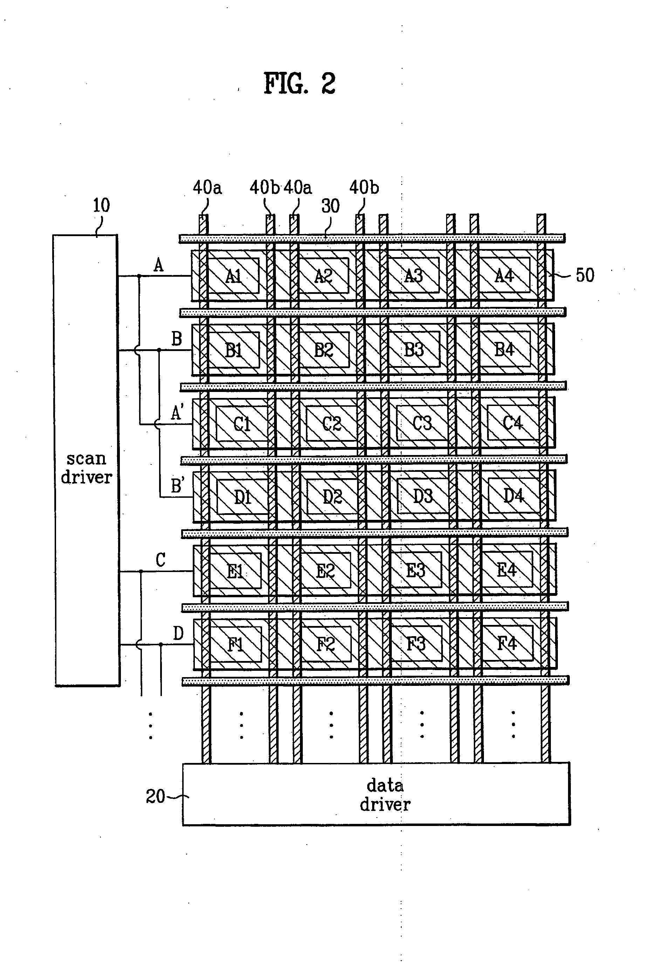

Reference will now be made in detail to the preferred embodiments of the present invention, examples of which are illustrated in the accompanying drawings. FIG 2 illustrates a diagram of an organic EL display panel in accordance with a preferred embodiment of the present invention.

Referring to FIG 2, the organic EL display panel includes a plurality of data lines 40 arranged in one direction, a plurality of scan lines 50 arranged perpendicular to the data lines 40, luminous pixels at cross points of the data lines 40 and the scan lines 50, an electric insulating barrier 30 between adjacent scan lines 50, a data driver 20 for driving the data line 40, and a scan driver 10 for driving the scan line 50.

Of the scan lines 50, two scan lines form one pair of scan lines to form a plurality of pairs of scan lines 50, and the data lines 40 include first data lines 40a and second data lines 40b.

Of the plurality of pairs of scan lines 50, the luminous pixels on odd numbered pairs of scan lines 50 are electrically connected to the first data lines 40a, and the luminous pixels on even numbered pairs of scan lines 50 are electrically connected to the second data lines 40b.

The pair of scan lines are two adjacent scan lines 50 arranged side by side. That is, odd numbered pair of scan lines includes first and second scan lines, and even numbered pair of scan lines includes third and fourth scan lines.

An arrangement of the data lines and the scan lines of the present invention will be described in more detail.

Referring to FIG. 2, luminous pixels A1, A2, A3, and A4, ---- on the first scan line 'A', and luminous pixels B1, B2, B3, B4, ---- on the second scan line 'B' are connected to the first data line.

Luminous pixels C1, C2, C3, and C4, ---- on the third scan line 'A", and luminous pixels D1, D2, D3, D4, ---- on the fourth scan line 'B" are connected to the second data line.

Also, luminous pixels E1, E2, E3, and E4, ---- on the fifth scan line 'C', and luminous pixels F1, F2, F3, F4, ---- on the sixth scan line 'D' are connected to the first data line.

Also, through not shown, luminous pixels on the seventh scan line, and luminous pixels on the eight scan line are connected to the second data line.

This system of connection can be expanded repeatedly according to a required size of the panel. That is, in the present invention, a plurality of pairs of scan lines are arranged, in which two scan lines form one pair.

Depending on cases, the organic EL display panel may have a system in which at least one scan line forms one group of scan lines, to form a plurality of groups of scan lines in total, luminous pixels on odd numbered groups of scan lines are connected to the first data line electrically, and luminous pixels on even numbered groups of scan lines are connected to the second data line electrically.

The operation method of the foregoing organic EL display panel will be described with reference to FIG. 2. Odd numbered pairs of scan lines and even numbered pairs of scan lines adjacent to the odd numbered pairs of scan lines are put into operation in the same order.

That is, the scan lines 'A' on the first pair of scan lines and the scan lines 'A" on the second pair of scan lines are driven at the same time when the first scan signal is provided, the scan lines 'B' on the first pair of scan lines and the scan lines 'B" on the second pair of scan lines are driven at the same time when the second scan signal is provided, and so on in a sequence.

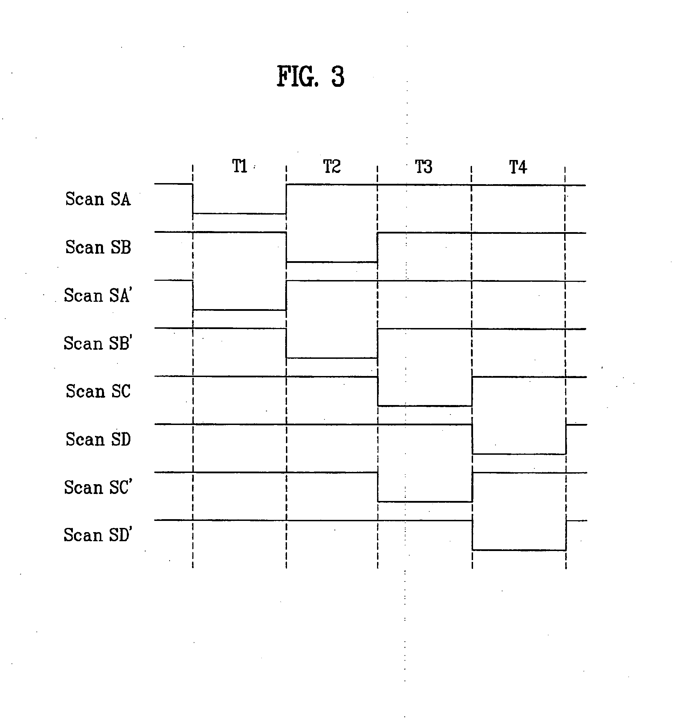

FIG. 3 illustrates a timing diagram of scan drive waveforms of an organic EL display panel in accordance with a preferred embodiment of the present invention, wherein T1, T2, T3, and T4 denote time periods required for driving each of the scan lines.

Referring to FIGS. 2 and 3, a scan signal SA denotes a signal provided to the first scan line 'A', a scan signal SA' denotes a signal provided to the third scan line 'A", a scan signal SB denotes a signal provided to the second scan line 'B', and a scan signal SB' denotes a signal provided to the fourth scan line 'B".

A scan signal SC denotes a signal provided to the fifth scan line 'C', a scan signal SC' denotes a signal provided to the seventh scan line (not shown), a scan signal SD denotes a signal provided to the sixth scan line 'D', and a scan signal SD' denotes a signal provided to the eighth scan line (not shown).

A sequence of operation of the scan lines is as follows.

In a T1 time period, the scan signal SA and the scan signal SA' are provided to the first scan line 'A' and the third scan line 'A".

In a T2 time period, the scan signal SB and the scan signal SB' are provided to the second scan line 'B' and the fourth scan line 'B", in a T3 time period, the scan signal SC and the scan signal SC' are provided to the fifth scan line 'C' and the seventh scan line 'C", and in a T4 time period, the scan signal SD and the scan signal SD' are provided to the sixth scan line and the eighth scan line.

Accordingly, the luminous pixels on the first scan line A and the luminous pixels on the second scan line B form pairs, and the luminous pixels on the third scan line A' and the luminous pixels on the fourth scan line B' form pairs.

Thus, all the luminous pixels in the display panel form pairs of two.

Odd numbered pairs of pixels are connected to one data line, and even numbered pairs of pixels are connected to another data line, so that the data lines are turned on/off according to the sequence of operation of the scan lines.

The scan signals to the scan lines are provided in an interlacing system.

In a first frame, the first scan line in the first pair of scan lines and the first scan line in the second pair of scan lines are driven at the same time when the first scan signal is provided, and the first scan line in the third pair of scan lines and the first scan line in the fourth pair of scan lines are driven at the same time when the second scan signal is provided.

In a second frame, the second scan line in the first pair of scan lines and the second scan line in the second pair of scan lines are driven at the same time when the first scan signal is provided, and the second scan line in the third pair of scan lines and the second scan line in the fourth pair of scan lines are driven at the same time when the second scan signal is provided.

Then, rest of the pairs of scan lines are driven in succession according to the foregoing order.

In this instance, a first frame time period, or a second frame time period is shorter than one frame time period required for driving entire luminous pixels in the display panel.

As has been explained, the flat display panel of the present invention has the following advantages.

Even if a scan frequency is dropped lower than the related art, no flicker is shown, and the dropping of the scan frequency permits reduction of power consumption.

The possibility of leading all the data lines only to one side permits to reduce costs for data driver chip and chip bonding by half compared to the related art. That is, as the flat display of the present invention can reduce a number of chips and a number of bonding, a production cost can be reduced.

It will be apparent to those skilled in the art that various modifications and variations can be made in the present invention without departing from the spirit or scope of the invention. Thus, it is intended that the present invention cover the modifications and variations of this invention provided they come within the scope of the appended claims and their equivalents.

The features of the description, the claims and the drawings, single or in any combination, are patentable, as far as not excluded by the prior art.

## Claims

1. A flat display panel comprising:
a plurality of data lines arranged in one direction;
a plurality of scan lines arranged perpendicular to the data lines; and
luminous pixels at cross points of the data lines and the scan lines,
wherein at least one scan line forms one group of scan lines, to form a plurality of groups of scan lines in total, luminous pixels on odd numbered groups of scan lines are connected to the first data line electrically, and luminous pixels on even numbered groups of scan lines are connected to the second data line electrically.

2. The flat display panel as claimed in claim 1, wherein the first data line is an odd numbered data line, and the second data line is an even numbered data line of the plurality of data lines.

3. The flat display panel as claimed in claim 1, wherein the odd numbered group of scan lines includes a first scan line and a second scan line, and the even numbered group of scan lines includes a third scan line and a fourth scan line.

4. The flat display panel as claimed in claim 1, wherein the scan lines in the odd numbered group of scan lines and scan lines in the even numbered group of scan lines adjacent thereto are driven in the same order at the same time.

5. A flat display panel comprising:
a plurality of data lines arranged in one direction;
a plurality of scan lines arranged perpendicular to the data lines; and
luminous pixels at cross points of the data lines and the scan lines,
wherein two scan line form one pair of scan lines, to form a plurality of pairs of scan lines in total, luminous pixels on odd numbered pairs of scan lines are connected to the first data line electrically, and luminous pixels on even numbered pairs of scan lines are connected to the second data line electrically.

6. The flat display panel as claimed in claim 5, wherein the pair of scan lines are two adjacent scan lines.

7. The flat display panel as claimed in claim 5, wherein the odd numbered pair of scan lines includes a first scan line and a second scan line, and the even numbered pair of scan lines includes a third scan line and a fourth scan line.

8. The flat display panel as claimed in claim 7, wherein the first, and second scan lines in the odd numbered pair of scan lines and the third and fourth scan lines in the even numbered pair of scan lines adjacent thereto are driven in the same order at the same time.

9. The flat display panel as claimed in claim 5, wherein the first data line is an odd numbered data line, and the second data line is an even numbered data line of the plurality of data lines.

10. The flat display panel as claimed in claim 5, wherein the first scan line of the first pair of scan lines and the first scan line of the second pair of scan lines are driven in response to the first scan signal, the second scan line of the first pair of scan lines and the second scan line of the second pair of scan lines are driven in response to the second scan signal, and other pairs of scan lines are driven according to above driving manner in a sequence.

11. The flat display panel as claimed in claim 5, wherein, in a first frame, the first scan line in the first pair of scan lines and the first scan line in the second pair of scan lines are driven at the same time when the first scan signal is provided, and the first scan line in the third pair of scan lines and the first scan line in the fourth pair of scan lines are driven at the same time when the second scan signal is provided, in a second frame, the second scan line in the first pair of scan lines and the second scan line in the second pair of scan lines are driven at the same time when the first scan signal is provided, and the second scan line in the third pair of scan lines and the second scan line in the fourth pair of scan lines are driven at the same time when the second scan signal is provided, and other pairs of scan lines are driven according to above driving manner in a sequence.

12. The flat display panel as claimed in claim 11, wherein the first frame, or the second frame has a time period shorter than one frame time period required for driving entire luminous pixels in the display panel.

13. The flat display panel as claimed in claim 5, wherein the scan signal to the scan line is provided in an interlacing manner.
